# EUROPEAN PATENT SPECIFICATION

(11) **EP 3 389 202 B1**
(45) Date of publication and mention of the grant of the patent: **05.10.2022**
(21) Application number: 17305449.5
(22) Date of filing: 14.04.2017
(51) Int. Cl.: H04J 3/24, H04J 3/06, H04L 27/00, H03M 9/00

(54) **MULTI-FREQUENCY TRANSMITTER AND ASSOCIATED METHOD**
MEHRFREQUENZ-SENDER UND ZUGEHÖRIGES VERFAHREN
TRANSMETTEUR MULTIFRÉQUENCE ET PROCÉDÉ ASSOCIÉ

(43) Date of publication of application: 17.10.2018
(73) Proprietor: Nokia Solutions and Networks Oy, 02610 Espoo (FI)
(72) Inventor: DUPAS, Arnaud, 91620 Nozay (FR); LAYEC, Patricia, 91620 Nozay (FR); DUTISSEUIL, Eric, 91620 Nozay (FR)
(74) Representative: Croonenbroek, Thomas Jakob

(56) References cited:
- EP-A2- 1 601 125
- US-A- 4 849 970
- US-A1- 2016 021 221
- US-B1- 7 330 924

## Description

### BACKGROUND OF THE INVENTION

The present invention relates to the field of communication networks and more precisely of transmission of data signals according to different frequencies.

In order to cope with traffic demand, communication networks have to always increase their throughput but need also to be flexible in order to adapt to sudden changes of traffic demand and meet the quality of signal required at destination. To achieve such goal, recent communication network comprises transmitter that are capable of transmitting signals with different frequencies or rates. The different frequencies are obtained by using a reconfigurable oscillator capable of generating different frequencies.

However, the reconfiguration of such oscillators requires a reconfiguration time in the range of a second so that traffic needs to be interrupted during this reconfiguration time which appears to be a problem especially in the case of continuous service offers.

It is therefore a goal of the present invention to overcome at least partially such technical problem and to provide a solution enabling a frequency switching that is hitless, that is to say which does not require any traffic interruption.

### SUMMARY OF THE INVENTION

The present invention refers to a transmitter comprising:
- a serializer comprising a plurality of inputs configured for receiving incoming data signals comprising successive data packets corresponding to a plurality of channels, the serializer being configured for serializing the said incoming data signals in an output signal,
   wherein the transmitter also comprises:
   - a first oscillator configured for providing a first clock signal associated to a first frequency to the serializer,
   - a second oscillator configured for providing a second clock signal associated to a second frequency different from the first frequency to the serializer,
   - a first fast switching device having a first input linked to the first oscillator, a second input linked to the second oscillator and an output linked to the serializer, the first fast switching device being configured for switching between a first switching state wherein the first input is linked to the output and a second switching state wherein the second input is linked to the output,
      and wherein the transmitter is configured, upon receipt of a clock signal change signal, for switching the first fast switching device from the first to the second switching state.

According to another aspect of the present invention, the switching of the first fast switching device is achieved during an interpacket gap in the incoming data packets.

According to another aspect of the present invention, the transmitter also comprises
- a digital to analog converter configured for converting a digital signal provided by the serializer in an analog signal using the same clock signal as the serializer,
- a second fast switching device having a first input linked to the first oscillator, a second input linked to the second oscillator and an output linked to the digital to analog converter, the second fast switching device being configured for switching between a first switching state wherein the first input is linked to the output and a second switching state wherein the second input is linked to the output, the second fast switching device being synchronized with the first fast switching device.

According to another aspect of the present invention, the switching from a first transmission frequency to a second transmission frequency corresponds to a change of modulation format.

According to another aspect of the present invention, the transmitter comprises a buffer configured for buffering the plurality of incoming data signals.

According to another aspect of the present invention, the transmitter comprises an electronic/optical converter configured for converting the transmitted signal and for transmitting the converted signal to an optical fiber linked to the transmitter.

According to another aspect of the present invention, the buffer, the serializer, and the at least one fast switching device are located on a common integrated circuit.

According to another aspect of the present invention, the switching from a first to a second transmission frequency comprises a transition via an intermediate frequency when the time required for switching from the first to the second frequency is higher than a predetermined duration threshold.

According to another aspect of the present invention, the predetermined duration threshold is determined based on the capacity of the buffer.

According to another aspect of the present invention, the intermediate frequency corresponds to a frequency in the range between the first and the second frequency.

According to another aspect of the present invention, the intermediate frequency corresponds to a standard frequency adapted to a receiver toward which the signal transmitted by the transmitter is destined and providing a stable state of the transmitter that is reached in a time shorter than the predetermined duration threshold.

According to another aspect of the present invention, the data packets of the incoming data signals are classified in different categories according to their importance and in case of a switching from a first frequency to a second frequency lower than the first frequency and/or a de-synchronization with the incoming data signals, only packets belonging to selected categories are transmitted by the serializer. An example of such a transmitter is disclosed by the document US2016/021221, James Johnson Neil, published on 21 January 2016.

The present invention also refers to a method for transmitting signals with different clock signals using a transmitter comprising:
- a serializer comprising a plurality of inputs configured for receiving incoming data signals comprising successive data packets corresponding to a plurality of channels, the serializer being configured for serializing the said incoming data signals in an output signal,
- a first oscillator configured for providing a first clock signal to the serializer,
- a second oscillator configured for providing a second clock signal to the serializer,
- a first fast switching device having a first input linked to the first oscillator, a second input linked to the second oscillator and an output linked to the serializer, the first fast switching device being configured for switching between a first switching state wherein the first input is linked to the output and a second switching state wherein the second input is linked to the output,
   and wherein the method comprises the following steps:
   - the first fast switching device is switched in the first switching state,
   - the serializer is driven for serializing the incoming data signals at a first transmission frequency using the first clock signal provided by the first oscillator,
      in case of a need to change the transmission frequency of the serializer from the first transmission frequency to a second transmission frequency different than the first frequency,
      if the difference between the first and the second frequency is smaller than a predetermined threshold,
         - the second oscillator is set so that the second clock signal corresponds to the second transmission frequency and,
         - the first fast switching device is switched to the second switching state,
         - the serializer is driven for serializing the incoming data signals using the second clock signal provided by the second oscillator,
            if the difference between the first and the third frequency is larger than a predetermined threshold,
         - the second oscillator is set so that the second clock signal corresponds to an intermediate frequency within the range between the first and the second frequency,
         - the fast switching device is switched to the second switching state,
         - the serializer is driven for serializing the incoming data signals using the second clock signal provided by the second oscillator corresponding to the intermediate frequency,
         - the first oscillator is set so that the first clock signal corresponds to the second frequency,
         - the fast switching device is switched to the first switching state,
         - the serializer is driven for serializing the incoming data signals using the first clock signal provided by the first oscillator corresponding to the second frequency.

According to another aspect of the present invention, the steps of switching the fast switching device from the first to the second switching state or from the second to the first switching state are achieved during an interpacket gap of the incoming data signals in the serializer.

According to another aspect of the present invention, the transmitter also comprises:
- a digital to analog converter linked to the output of the serializer,
- a second fast switching device having a first input linked to the first oscillator, a second input linked to the second oscillator and an output linked to the digital to analog converter, the second fast switching device being configured for switching between a first switching state wherein the first input is linked to the output and a second switching state wherein the second input is linked to the output, the second fast switching device being synchronized with the first fast switching device for switching from one switching state to the other.

According to another aspect of the present invention, the method comprises a preliminary step of classification of the packets of the incoming data signals into different categories and wherein in case of a switching from a first frequency to a second frequency lower than the first frequency and a de-synchronization with the incoming data signals, only packets belonging to selected categories are transmitted by the serializer.

### BRIEF DESCRIPTION OF THE DRAWINGS

FIG.1 is a diagram of a serializer and two oscillators configured for providing a clock signal to the serializer,
FIG.2 is a diagram of a transmitter according to a first embodiment,
FIG.3 is a flowchart of the different steps of the transmission method according to the present invention,
FIG.4 is a diagram of a transmitter according to a second embodiment;
FIG.5 is a diagram of a transmitter according to a third embodiment;

### DETAILED DESCRIPTION OF THE INVENTION

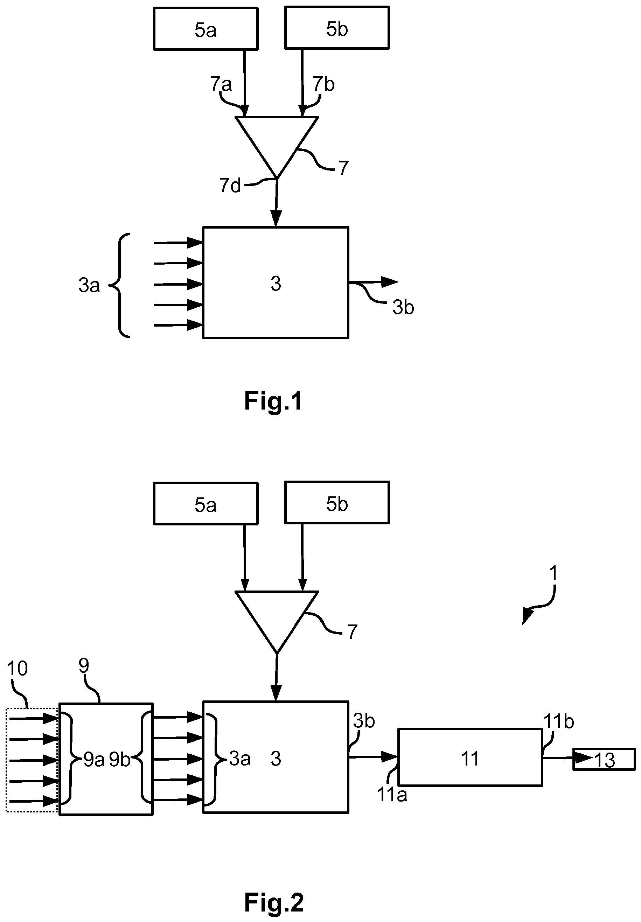

Fig.1 represents a diagram of a serializer 3. The serializer 3 comprises a plurality of inputs 3a configured for receiving a plurality of incoming data signals corresponding to packet streams also called data bus. The different incoming data signals may have different throughputs or the same throughput. The serializer 3 also comprises an output 3b configured for transmitting a single outgoing data signal corresponding to a single stream of packets corresponding to the combination of the different incoming signals. The serializer 3 enables therefore to serializes a plurality of parallel bitstreams into a single bitstream having a bit rate corresponding to the sum of the bitrates of the parallel incoming bitstreams. In order to achieve such serialization, a clock signal corresponding to the frequency (or symbol rate) of the outgoing signal has to be supplied to the serializer 3. Such clock signal is provided by an oscillator.

In the present case, a first reconfigurable oscillator 5a and a second reconfigurable oscillator 5b are used to supply a clock signal in order to enable a fast switching between the first oscillator 5a and the second oscillator 5b. Indeed, in order to deal with a variable number of incoming data signals and/or incoming data signals having variable throughput, the serializer 3 has to work at different frequencies depending on the demand so that a clock signal corresponding to the desired frequency has to be supplied to the serializer 3. A reconfigurable oscillator 5a, 5b is capable of providing clock signal at different frequencies but the reconfiguration time is generally very long with respect to the bitrate of the incoming signals so that a combination of two reconfigurable oscillators 5a and 5b needs to be used in order to reduce the time required for switching from a clock signal at a first frequency to a clock signal at a second frequency. A fast switching device 7 is used to enable the switching from the first reconfigurable oscillator 5a to the second reconfigurable oscillator 5b. The fast switching device 7 comprises a first input 7a linked to the first reconfigurable oscillator 5a, a second input 7b linked to the second reconfigurable oscillator 5b and an output 7d linked to the serializer 3. The fast switching device 7 is configured for linking one of the inputs 7a or 7b to the output 7d. The fast switching device 7 is also configured for switching, upon receipt of a frequency change signal, from a first switching state wherein the first input 7a is linked to the output 7d (the second input 7b is then not linked to the output 7d) to a second switching state wherein the second input 7b is linked to the output 7d (the first input 7a is then not linked to the output 7d) and inversely. The fast switching device 7 may be achieved with a field programmable gate array element, for example a Virtex^{®}-7 FPGA. However, any other fast switching element known in the state of the art and enabling a switching from the first switching state to the second switching state in a range of a nanosecond or a few ns may also be used.

Fig.2 represents a transmitter 1 according to a first embodiment. The transmitter 1 comprises a serializer 3, a first 5a and a second 5b reconfigurable oscillators and a fast switching device 7 as described in Fig.1. The transmitter 1 also comprises a buffer 9 comprising a plurality of inputs 9a configured for receiving and buffering the plurality of incoming data signals received by the transmitter 1. These incoming data signals correspond for example to a data bus 10 connected to the transmitter 1. The buffer 9 also comprises a plurality of outputs 9b linked respectively to the inputs of the serializer 3. The buffer 9 is configured for transmitting the buffered data signals to the serializer according to a predefined timing, each data signals being transmitted according to a predefined rate. The buffer 9 enables avoiding an interruption within a packet.

The serializer3, the fast switching device 7 and the buffer 9 may be implemented on a common integrated circuit.

The transmitter 3 may also comprise an electronic to optical converter 11. The electronic to optical converter 11 comprises an input 11a linked to the output 3b of the serializer 3 and an output 11b linked to an optical fiber 13. The electronic to optical converter is configured for converting the electronic data signal transmitted by the serializer 3 into an optical signal.

The transmitter 1 is destined to be implemented into an ingress node of an optical network. Thus, the optical signal outputted by the electronic to optical converter 11 may then be transmitted toward a receiver of an egress node (not represented) via an optical link corresponding to the optical fiber 13. Furthermore, the transmitter 1 may be connected to a control plane unit (not represented) of the network configured for managing the data transmissions through the network. The control plane unit may be configured for transmitting a required frequency signal or a frequency change signal in order for the serializer 3 to be configured to produce an output signal at the required frequency signal. The control plane unit may be located in a central controller of the network which is remote from the transmitter 1.

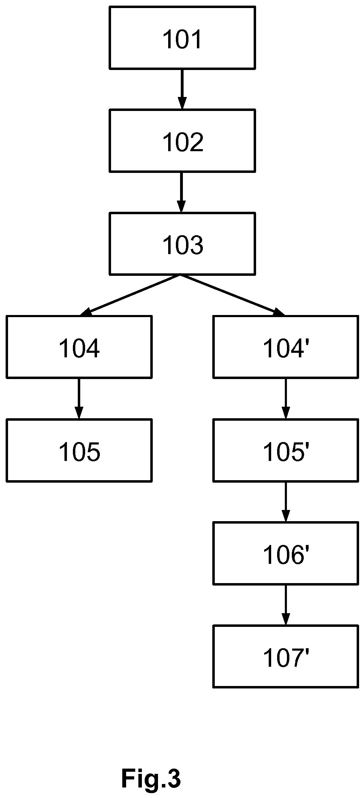

The different steps of a method for transmitting a data signal comprising a change in the frequency of the transmitted signal based on the transmitter 1 described in Fig.2 will now be described based on the flowchart of Fig.3.

The first step 101 refers to the configuration of the transmitter 1 in order to transmit a data signal according to a first frequency produced by the first reconfigurable oscillator 5a so that the fast switching device 7 is in the first switching state.

The second step 102 refers to the reception of a frequency change signal sent by a control plane unit to the transmitter 1 indicating that the data signal frequency has to be switched to a second frequency at a predefined time T1.

The third step 103 corresponds to an estimation of the duration for switching from the first to the second frequency. This estimation may be achieved based on preliminary tests to determine the switching time for the frequencies associated to the possible transmitted signals. Such duration depends for example on the absolute value of the difference between the first and the second frequencies and on the time required by the serializer 3 to find a stable state in the second frequency. This estimated duration is then compared with a predetermined duration threshold. If the estimated duration is shorter than or equal to the predetermination duration threshold, the method goes to step 104 and if the estimated difference is higher than the predefined duration threshold, the method goes to step 104'.

The predetermined duration may be chosen based on the buffer 9 capacity. Indeed, depending on the throughput of the transmitter 1, the buffer 9 capacity may allow to buffer the transmitted packets during a predetermined duration, for example 1ms. In such case, the predetermined duration is then chosen to be 1ms or less in order for the transmitter 1 to be able to switch from one frequency to the other during the maximum buffering time to ensure that no data packets are lost during the frequency switching.

When the estimated duration is shorter than the predetermination duration threshold in step 103, the fourth step 104 corresponds to the configuration of the second reconfigurable oscillator 5b at the second frequency.

The fifth step 105 refers to the switching at the predefined time T1 of the fast switching device 1 to the second switching state and the configuration of the serializer 3 to transmit an output data signal at the second frequency. Preferably, the switching is achieved during an interpacket gap, for example the next interpacket gap after the predefined time T1.

When the estimated duration is longer than or equal to the predetermination duration threshold in step 103, the step 104' refers to the configuration of the second reconfigurable oscillator 5b to an intermediate frequency comprised in the range between the first and the second frequency, for example around half of the difference from the first and the second frequencies. Preferably, the intermediate frequency is chosen among a standard set of frequencies in order to enable a stable configuration of the second reconfigurable oscillator 5b at the intermediate frequency. The standard frequency is for example chosen to be adapted to the receiver toward which the signal transmitted by the transmitter 1 is destined and to provide a stable state of the transmitter 1 that is reached in a time shorter than the predetermined duration threshold.

When the estimated duration is longer than the predetermination duration threshold in step 103, the step 105' corresponds to the switching at the predefined time T1 of the fast switching device 7 to the second switching state and the configuration of the serializer 3 in order to transmit an output data signal at the intermediate frequency. Preferably, the switching is achieved during an interpacket gap.

The step 106' refers to the configuration of the first reconfigurable oscillator 5a at the second frequency.

The step 107' refers to the switching at the predefined time T1 of the fast switching device 7 to the first switching state and the configuration of the serializer 3 to transmit an output data signal at the second frequency. Preferably, the switching is achieved during an interpacket gap, for example the next interpacket gap after the predefined time T1.

The use of an intermediate frequency enables to switch from a first frequency to a second frequency without requiring a long reconfiguration due to the long stabilization of the serializer 3 due to the frequency difference. Alternatively, several intermediate frequencies can be used.

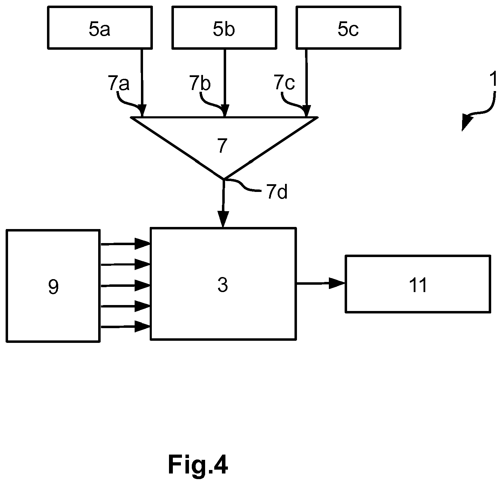

Fig.4 represents a transmitter 1 according to a second embodiment. This embodiment differs from the first embodiment represented in fig.2 in that it comprises a third reconfigurable oscillator 5c and in that the fast switching device 7 comprises a third input 7c and a third switching state wherein the third input 7c is linked to the output 7d. The third input 7c being linked to the third reconfigurable oscillator 5c. The other elements of the transmitter 1 remains identical to the transmitter 1 of the first embodiment.

With such transmitter 1, to switch from the first frequency to the second frequency via the intermediate frequency, the second reconfigurable oscillator 5b can be configured to transmit a signal at the intermediate frequency and the third reconfigurable oscillator 5c can be configured to transmit a signal at the second frequency. The fast switching device 7 is then switched successively from the first to the second switching state and from the second to the third switching state. The different switchings are for example launched by a frequency change signal sent by a control plane unit to the transmitter 1 indicating that the data signal frequency has to be switched to a second frequency at a predefined time T1. The switchings being achieved preferably during inter-packet gaps. The time lasts using the intermediate frequency may be as short as possible.

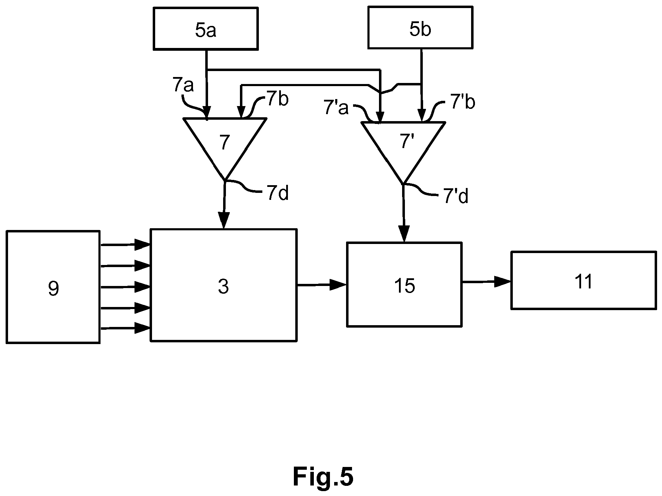

Fig.5 represents a transmitter 1 according to a third embodiment. This embodiment differs from the first embodiment represented in fig.2 in that it comprises a digital to analog converter 15. The digital to analog converter 15 is implemented at the output of the serializer 3.The output of the digital to analog converter 15 is linked to the optical converter 11. The digital to analog converter 15 is configured for converting the digital signal provided by the serializer 3 into an analog signal. The digital to analog converter 15 is configured for using the same clock signal as the serializer 3.

A second fast switching device 7' is therefore used for providing the clock signal providing by the first 5a or the second 5b reconfigurable oscillators to the digital to analog converter 15. The second fast switching device 7' has a first input 7'a linked to the first oscillator 5a, a second input 7'b linked to the second oscillator 5b and an output 7'd linked to the digital to analog converter 15. The second fast switching device 7' being configured for switching between a first switching state wherein its first input 7'a is linked to the output 7'd and a second switching state wherein its second input 7'b is linked to its output 7'd. Furthermore, the second fast switching device 7' is synchronized with the first fast switching device 7 so that the switchings from one switching state to the other are achieved simultaneously by both fast switching devices 7 and 7'. Both fast switching devices 7 and 7' can be implemented on a common integrated circuit. The integrated circuit may also comprise the buffer 9 and the serializer 3.

The other elements of the transmitter 1 remains identical to the transmitter of the first embodiment.

The digital to analog converter 15 enables to change the modulation format. Thus, the switching of frequency may correspond to a switching of modulation format. Indeed, the digital to analog converter 15 is configured for converting digital levels in analog signals. The total number of digital levels depends on the capacity of the digital to analog converter 15, for example 32 levels for a 5-bit converter and the number of used levels may be adapted to the modulation format and the levels values may be adapted to the used modulation format. In general, two digital to analog converters are used in parallel in order to process the two different polarizations of the signal.

Furthermore, for all the embodiments described above, the data packets of the incoming data signals may be classified in different categories according to their importance. Thus, in case of a switching from a first frequency to a second frequency lower than the first frequency and/or a de-synchronization with the incoming data signals, only packets belonging to selected categories are transmitted by the serializer 3. Indeed, if a frequency change signal is received by the transmitter 1 at a time T1, there may be a time shift between the reception of the frequency change signal, or the predefined time T1 of the switching, and the change in the incoming data signals of the data bus 10. Such time shift or de-synchronization may therefore lead to a loss of the packets notably if the frequency is switched to a lower frequency (corresponding to a lower throughput). The classification of the packets may then enable to avoid the loss of the most important packets.

The present invention, by the use of at least two reconfigurable oscillators 5a and 5b and at least one fast switching device 7, enables a hitless frequency switching wherein such frequency switching does not lead to an interruption of the traffic nor to a loss of data packets. Such features are particularly interesting for continuous data transmission in high throughput communication network.

The functions of the various elements shown in the FIGs., including any functional blocks labeled as "processors", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the FIGS. are conceptual only. Their function may be carried out through the operation of program logic, through dedicated logic, through the interaction of program control and dedicated logic, or even manually, the particular technique being selectable by the implementer as more specifically understood from the context.

## Claims

1. Transmitter (1) comprising:
- a serializer (3) comprising a plurality of inputs (3a) configured for receiving incoming data signals comprising successive data packets corresponding to a plurality of channels, the serializer being configured for serializing the said incoming data signals in an output signal,
wherein the transmitter (1) also comprises:
- a first oscillator (5a) configured for providing a first clock signal associated to a first frequency to the serializer (3),
- a second oscillator (5b) configured for providing a second clock signal associated to a second frequency different from the first frequency to the serializer (3),
- a first fast switching device (7) having a first input (7a) linked to the first oscillator (5a), a second input (7b) linked to the second oscillator (5b) and an output (7d) linked to the serializer (3), the first fast switching device (7) being configured for switching between a first switching state wherein the first input (7a) is linked to the output (7d) and a second switching state wherein the second input (7b) is linked to the output (7d),
- a buffer (9) configured for buffering the plurality of incoming data signals, **characterized in that** the transmitter (1) is configured, upon receipt of a clock signal change signal, for switching the first fast switching device (7) from the first to the second switching state during an interpacket gap in the incoming data packets.

2. Transmitter (1) in accordance with claim 1 comprising
- a digital to analog converter (15) configured for converting a digital signal provided by the serializer (3) in an analog signal using the same clock signal as the serializer (3),
- a second fast switching device (7') having a first input (7'a) linked to the first oscillator (5a), a second input (7'b) linked to the second oscillator (5b) and an output (7d) linked to the digital to analog converter (15), the second fast switching device (7') being configured for switching between a first switching state wherein the first input (7'a) is linked to the output (7'd) and a second switching state wherein the second input (7'b) is linked to the output (7'd), the second fast switching device (7') being synchronized with the first fast switching device (7).

3. Transmitter (1) in accordance with claim 2 wherein the switching from a first transmission frequency to a second transmission frequency corresponds to a change of modulation format.

4. Transmitter (1) in accordance with one of the previous claims comprising an electronic/optical converter (11) configured for converting the transmitted signal and for transmitting the converted signal to an optical fiber (13) linked to the transmitter (1).

5. Transmitter (1) in accordance with one of the previous claims wherein the buffer (9), the serializer (3), and the at least one fast switching device (7, 7') are located on a common integrated circuit.

6. Transmitter (1) in accordance with one of the previous claims wherein the switching from a first to a second transmission frequency comprises a transition via an intermediate frequency when a time required for switching from the first to the second frequency is higher than a predetermined duration threshold.

7. Transmitter (1) in accordance with one of the previous claims wherein the predetermined duration threshold is determined based on the capacity of the buffer (9).

8. Transmitter (1) in accordance with claim 6 or 7 wherein the intermediate frequency corresponds to a frequency in the range between the first and the second frequency.

9. Transmitter (1) in accordance with claim 8 wherein the intermediate frequency corresponds to a standard frequency which is selected among a set of frequencies adapted to a receiver toward which the signal transmitted by the transmitter (1) is destined and is adapted to provide a stable state of the transmitter (1) that is reached in a time shorter than the predetermined duration threshold.

10. Transmitter (1) in accordance with one of the previous claims wherein the data packets of the incoming data signals are classified in different categories according to their importance and in case of a switching from a first frequency to a second frequency lower than the first frequency and/or a de-synchronization with the incoming data signals, only packets belonging to selected categories are transmitted by the serializer (3).

11. Method for transmitting signals with different clock signals using a transmitter (1) comprising:
- a serializer (3) comprising a plurality of inputs (3a) configured for receiving incoming data signals, which are received from an output of a buffer (9), comprising successive data packets corresponding to a plurality of channels, the serializer (3) being configured for serializing the said incoming data signals in an output signal,
- a first oscillator (5a) configured for providing a first clock signal to the serializer (3),
- a second oscillator (5b) configured for providing a second clock signal to the serializer (3),
- a first fast switching device (7) having a first input (7a) linked to the first oscillator (5a), a second input (7b) linked to the second oscillator (5b) and an output (7d) linked to the serializer (3), the first fast switching device (7) being configured for switching between a first switching state wherein the first input (7a) is linked to the output (7d) and a second switching state wherein the second input (7b) is linked to the output (7d), **characterized in that** the method comprises the following steps:
- the first fast switching device (7) is switched in the first switching state,
- the serializer (3) is driven for serializing the incoming data signals at a first transmission frequency using the first clock signal provided by the first oscillator (5a),
in case of a need to change the transmission frequency of the serializer (3) from the first transmission frequency to a second transmission frequency different than the first frequency,
if the difference between the first and the second frequency is smaller than a predetermined threshold,
- the second oscillator (5b) is set so that the second clock signal corresponds to the second transmission frequency and,
- the first fast switching device (7) is switched to the second switching state,
- the serializer (3) is driven for serializing the incoming data signals using the second clock signal provided by the second oscillator (5b),
if the difference between the first and the third frequency is larger than a predetermined threshold,
- the second oscillator (5b) is set so that the second clock signal corresponds to an intermediate frequency within the range between the first and the second frequency,
- the fast switching device (7) is switched to the second switching state,
- the serializer (3) is driven for serializing the incoming data signals using the second clock signal provided by the second oscillator (5b) corresponding to the intermediate frequency,
- the first oscillator (5a) is set so that the first clock signal corresponds to the second frequency,
- the fast switching device (7) is switched to the first switching state,
- the serializer (3) is driven for serializing the incoming data signals using the first clock signal provided by the first oscillator (5a) corresponding to the second frequency
and wherein the steps of switching the fast switching device (7) from the first to the second switching state or from the second to the first switching state are achieved during an interpacket gap of the incoming data signals in the serializer (3).

12. Method in accordance with claim 11 wherein the transmitter (1) also comprises:
- a digital to analog converter (15) linked to the output of the serializer (3),
- a second fast switching device (7') having a first input (7'a) linked to the first oscillator (5a), a second input (7'b) linked to the second oscillator (5b) and an output (7'd) linked to the digital to analog converter (15), the second fast switching device (7') being configured for switching between a first switching state wherein the first input (7'a) is linked to the output (7'd) and a second switching state wherein the second input (7'b) is linked to the output (7'd), the second fast switching device (7') being synchronized with the first fast switching device (7) for switching from one switching state to the other.

## Patentansprüche

1. Sender (1), umfassend:
- einen Serialisierer (3) mit mehreren Eingängen (3a), ausgelegt zum Empfangen von ankommenden Datensignalen, die sukzessive Datenpakete umfassen, die mehreren Kanälen entsprechen, wobei der Serialisierer ausgelegt ist zum Serialisieren der ankommenden Datensignale in einem Ausgangssignal,
wobei der Sender (1) außerdem Folgendes umfasst:
- einen ersten Oszillator (5a), ausgelegt zum Bereitstellen eines einer ersten Frequenz zugeordneten ersten Taktsignals für den Serialisierer (3),
- einen zweiten Oszillator (5b), ausgelegt zum Bereitstellen eines einer von der ersten Frequenz verschiedenen zweiten Frequenz zugeordneten zweiten Taktsignals für den Serialisierer (3),
- eine erste schnelle Schaltvorrichtung (7) mit einem mit dem ersten Oszillator (5a) verbundenen ersten Eingang (7a), einem mit dem zweiten Oszillator (5b) verbundenen zweiten Eingang (7b) und einem mit dem Serialisierer (3) verbundenen Ausgang (7d), wobei die erste schnelle Schaltvorrichtung (7) ausgelegt ist zum Umschalten zwischen einem ersten Schaltzustand, in dem der erste Eingang (7a) mit dem Ausgang (7d) verbunden ist, und einem zweiten Schaltzustand, in dem der zweite Eingang (7b) mit dem Ausgang (7d) verbunden ist,
- einen Puffer (9), ausgelegt zum Puffern der mehreren ankommenden Datensignale,
**dadurch gekennzeichnet, dass** der Sender (1) dafür ausgelegt ist, bei Empfang eines Taktsignal-Änderungssignals die erste schnelle Schaltvorrichtung (7) während einer Lücke zwischen Paketen in den ankommenden Datenpaketen aus dem ersten in den zweiten Schaltzustand zu überführen.

2. Sender (1) nach Anspruch 1, umfassend:
- einen Digital-Analog-Umsetzer (15), ausgelegt zum Umsetzen eines durch den Serialisierer (3) bereitgestellten Digitalsignals in ein Analogsignal unter Verwendung desselben Taktsignals wie der Serialisierer (3),
- eine zweite schnelle Schaltvorrichtung (7') mit einem mit dem ersten Oszillator (5a) verbundenen ersten Eingang (7'a), einem mit dem zweiten Oszillator (5b) verbundenen zweiten Eingang (7'b) und einem mit dem Digital-Analog-Umsetzer (15) verbundenen Ausgang (7'd), wobei die zweite schnelle Schaltvorrichtung (7') ausgelegt ist zum Umschalten zwischen einem ersten Schaltzustand, in dem der erste Eingang (7'a) mit dem Ausgang (7'd) verbunden ist, und einem zweiten Schaltzustand, in dem der zweite Eingang (7'b) mit dem Ausgang (7'd) verbunden ist, wobei die zweite schnelle Schaltvorrichtung (7') mit der ersten schnellen Schaltvorrichtung (7) synchronisiert ist.

3. Sender (1) nach Anspruch 2, wobei das Umschalten von einer ersten Übertragungsfrequenz auf eine zweite Übertragungsfrequenz einer Modulationsformatänderung entspricht.

4. Sender (1) nach einem der vorhergehenden Ansprüche, der einen Elektronisch/Optisch-Umsetzer (11) umfasst, der dafür ausgelegt ist, das gesendete Signal umzusetzen und das umgesetzte Signal zu einer mit dem Sender (1) verbundenen optischen Faser (13) zu senden.

5. Sender (1) nach einem der vorhergehenden Ansprüche, wobei sich der Puffer (9), der Serialisierer (3) und die mindestens eine schnelle Schaltvorrichtung (7, 7') auf einer gemeinsamen integrierten Schaltung befinden.

6. Sender (1) nach einem der vorhergehenden Ansprüche, wobei das Umschalten von einer ersten auf eine zweite Übertragungsfrequenz einen Übergang über eine Zwischenfrequenz umfasst, wenn eine zum Umschalten von der ersten auf die zweite Frequenz erforderliche Zeit höher als eine vorbestimmte Dauerschwelle ist.

7. Sender (1) nach einem der vorhergehenden Ansprüche, wobei die vorbestimmte Dauerschwelle auf der Basis der Kapazität des Puffers (9) bestimmt wird.

8. Sender (1) nach Anspruch 6 oder 7, wobei die Zwischenfrequenz einer Frequenz im Bereich zwischen der ersten und der zweiten Frequenz entspricht.

9. Sender (1) nach Anspruch 8, wobei die Zwischenfrequenz einer Standardfrequenz entspricht, die aus einer Menge von Frequenzen ausgewählt wird, die für einen Empfänger ausgelegt ist, für den das durch den Sender (1) gesendete Signal bestimmt ist, und dafür ausgelegt ist, einen stabilen Zustand des Senders (1) bereitzustellen, der in einer Zeit erreicht wird, die kürzer als die vorbestimmte Dauerschwelle ist.

10. Sender (1) nach einem der vorhergehenden Ansprüche, wobei die Datenpakete der ankommenden Datensignale gemäß ihrer Wichtigkeit in verschiedene Kategorien eingeteilt werden und im Fall eines Umschaltens von einer ersten Frequenz auf eine zweite Frequenz, die niedriger als die erste Frequenz ist, und/oder einer Desynchronisation mit den ankommenden Datensignalen nur Pakete, die zu ausgewählten Kategorien gehören, durch den Serialisierer (3) gesendet werden.

11. Verfahren zum Senden von Signalen mit verschiedenen Taktsignalen unter Verwendung eines Senders (1), umfassend:
- einen Serialisierer (3) mit mehreren Eingängen (3a), ausgelegt zum Empfangen ankommender Datensignale, die von einem Ausgang eines Puffers (9) empfangen werden, die sukzessive Datenpakete umfassen, die mehreren Kanälen entsprechen, wobei der Serialisierer (3) ausgelegt ist zum Serialisieren der ankommenden Datensignale in einem Ausgangssignal,
- einen ersten Oszillator (5a), ausgelegt zum Bereitstellen eines ersten Taktsignals für den Serialisierer (3),
- einen zweiten Oszillator (5b), ausgelegt zum Bereitstellen eines zweiten Taktsignals für den Serialisierer (3),
- eine erste schnelle Schaltvorrichtung (7) mit einem mit dem ersten Oszillator (5a) verbundenen ersten Eingang (7a), einem mit dem zweiten Oszillator (5b) verbundenen zweiten Eingang (7b) und einem mit dem Serialisierer (3) verbundenen Ausgang (7d), wobei die erste schnelle Schaltvorrichtung (7) ausgelegt ist zum Umschalten zwischen einem ersten Schaltzustand, in dem der erste Eingang (7a) mit dem Ausgang (7d) verbunden ist, und einem zweiten Schaltzustand, in dem der zweite Eingang (7b) mit dem Ausgang (7d) verbunden ist,
**dadurch gekennzeichnet, dass** das Verfahren die folgenden Schritte umfasst:
- die erste schnelle Schaltvorrichtung (7) wird in den ersten Schaltzustand umgeschaltet,
- der Serialisierer (3) wird angesteuert zur Serialisierung der ankommenden Datensignale mit einer ersten Übertragungsfrequenz unter Verwendung des durch den ersten Oszillator (5a) bereitgestellten ersten Taktsignals,
im Fall einer Notwendigkeit, die Übertragungsfrequenz des Serialisierers (3) von der ersten Übertragungsfrequenz in eine von der ersten Frequenz verschiedene zweite Übertragungsfrequenz umzuändern,
wenn die Differenz zwischen der ersten und zweiten Frequenz kleiner als eine vorbestimmte Schwelle ist,
- wird der zweite Oszillator (5b) so eingestellt, dass das zweite Taktsignal der zweiten Übertragungsfrequenz entspricht, und
- wird die erste schnelle Schaltvorrichtung (7) in den zweiten Schaltzustand umgeschaltet,
- wird der Serialisierer (3) angesteuert zum Serialisieren der ankommenden Datensignale unter Verwendung des durch den zweiten Oszillator (5b) bereitgestellten zweiten Taktsignals,
wenn die Differenz zwischen der ersten und zweiten Frequenz größer als eine vorbestimmte Schwelle ist,
- wird der zweite Oszillator (5b) so eingestellt, dass das zweite Taktsignal einer Zwischenfrequenz in dem Bereich zwischen der ersten und der zweiten Frequenz entspricht,
- wird die schnelle Schaltvorrichtung (7) in den zweiten Schaltzustand umgeschaltet,
- wird der Serialisierer (3) angesteuert zum Serialisieren der ankommenden Datensignale unter Verwendung des durch den zweiten Oszillator (5b) bereitgestellten zweiten Taktsignals, das der Zwischenfrequenz entspricht,
- wird der erste Oszillator (5a) so eingestellt, dass das erste Taktsignal der zweiten Frequenz entspricht,
- wird die schnelle Schaltvorrichtung (7) in den ersten Schaltzustand umgeschaltet,
- wird der Serialisierer (3) angesteuert zum Serialisieren der ankommenden Datensignale unter Verwendung des durch den ersten Oszillator (5a) bereitgestellten ersten Taktsignals, das der zweiten Frequenz entspricht,
und werden die Schritte des Umschaltens der schnellen Schaltvorrichtung (7) von dem ersten auf den zweiten Schaltzustand oder von dem zweiten auf den ersten Schaltzustand während einer Lücke zwischen Paketen der ankommenden Datensignale in dem Serialisierer (3) erzielt.

12. Verfahren nach Anspruch 11, wobei der Sender (1) außerdem Folgendes umfasst:
- einen Digital-Analog-Umsetzer (15), der mit dem Ausgang des Serialisierers (3) verbunden ist,
- eine zweite schnelle Schaltvorrichtung (7') mit einem mit dem ersten Oszillator (5a) verbundenen ersten Eingang (7'a), einem mit dem zweiten Oszillator (5b) verbundenen zweiten Eingang (7'b) und einem mit dem Digital-Analog-Umsetzer (15) verbundenen Ausgang (7'd), wobei die zweite schnelle Schaltvorrichtung (7') ausgelegt ist zum Umschalten zwischen einem ersten Schaltzustand, in dem der erste Eingang (7'a) mit dem Ausgang (7'd) verbunden ist, und einem zweiten Schaltzustand, in dem der zweite Eingang (7'b) mit dem Ausgang (7'd) verbunden ist, wobei die zweite schnelle Schaltvorrichtung (7') mit der ersten schnellen Schaltvorrichtung (7) synchronisiert ist, zum Umschalten von einem Schaltzustand auf den anderen.

## Revendications

1. Émetteur (1) comprenant :
- un sérialiseur (3) comprenant une pluralité d'entrées (3a) configurées pour recevoir des signaux de données entrants comprenant des paquets de données successifs correspondant à une pluralité de canaux, le sérialiseur étant configuré pour sérialiser lesdits signaux de données entrants dans un signal de sortie,
l'émetteur (1) comprenant également :
- un premier oscillateur (5a) configuré pour fournir un premier signal d'horloge associé à une première fréquence au sérialiseur (3),
- un deuxième oscillateur (5b) configuré pour fournir un deuxième signal d'horloge associé à une deuxième fréquence différente de la première fréquence au sérialiseur (3),
- un premier dispositif de commutation rapide (7) possédant une première entrée (7a) liée au premier oscillateur (5a), une deuxième entrée (7b) liée au deuxième oscillateur (5b) et une sortie (7d) liée au sérialiseur (3), le premier dispositif de commutation rapide (7) étant configuré pour commuter entre un premier état de commutation, la première entrée (7a) étant liée à la sortie (7d), et un deuxième état de commutation, la deuxième entrée (7b) étant liée à la sortie (7d),
- un tampon (9) configuré pour mettre en tampon la pluralité de signaux de données entrants, **caractérisé en ce que** le transmetteur (1) est configuré, après la réception d'un signal de changement de signal d'horloge, pour commuter le premier dispositif de commutation rapide (7) du premier au deuxième état de commutation pendant un intervalle inter-paquets dans les paquets de données entrants.

2. Émetteur (1) selon la revendication 1 comprenant
- un convertisseur numérique-analogique (15) configuré pour convertir un signal numérique fourni par le sérialiseur (3) en un signal analogique en utilisant le même signal d'horloge que le sérialiseur (3),
- un deuxième dispositif de commutation rapide (7') possédant une première entrée (7'a) liée au premier oscillateur (5a), une deuxième entrée (7'b) liée au deuxième oscillateur (5b) et une sortie (7'd) liée au convertisseur numérique-analogique (15), le deuxième dispositif de commutation rapide (7') étant configuré pour commuter entre un premier état de commutation, la première entrée (7'a) étant liée à la sortie (7'd), et un deuxième état de commutation, la deuxième entrée (7'b) étant liée à la sortie (7'd), le deuxième dispositif de commutation rapide (7') étant synchronisé avec le premier dispositif de commutation rapide (7).

3. Émetteur (1) selon la revendication 2, la commutation d'une première fréquence de transmission à une deuxième fréquence de transmission correspondant à un changement de format de modulation.

4. Émetteur (1) selon l'une des revendications précédentes comprenant un convertisseur électronique/optique (11) configuré pour convertir le signal transmis et pour transmettre le signal converti à une fibre optique (13) liée à l'émetteur (1).

5. Émetteur (1) selon l'une des revendications précédentes, le tampon (9), le sérialiseur (3), et l'au moins un dispositif de commutation rapide (7, 7') étant situés sur un circuit intégré commun.

6. Émetteur (1) selon l'une des revendications précédentes, la commutation d'une première à une deuxième fréquence de transmission comprenant une transition via une fréquence intermédiaire lorsqu'un temps requis pour la commutation de la première à la deuxième fréquence est supérieur à un seuil de durée prédéterminé.

7. Émetteur (1) selon l'une des revendications précédentes, le seuil de durée prédéterminé étant déterminé sur la base de la capacité du tampon (9).

8. Émetteur (1) selon la revendication 6 ou 7, la fréquence intermédiaire correspondant à une fréquence dans la plage entre la première et la deuxième fréquence.

9. Émetteur (1) selon la revendication 8, la fréquence intermédiaire correspondant à une fréquence standard laquelle est sélectionnée parmi un ensemble de fréquences adaptées à un récepteur auquel le signal transmis par l'émetteur (1) est destiné et est adaptée à fournir un état stable de l'émetteur (1) qui est atteint en un temps plus court que le seuil de durée prédéterminé.

10. Émetteur (1) selon l'une des revendications précédentes, les paquets de données des signaux de données entrants étant classifiés en différentes catégories en fonction de leur importance et, en cas de commutation d'une première fréquence à une deuxième fréquence plus basse que la première fréquence et/ou de désynchronisation avec les signaux de données entrants, seuls des paquets appartenant à des catégories sélectionnées sont transmis par le sérialiseur (3).

11. Procédé de transmission de signaux avec des signaux d'horloge différents en utilisant un émetteur (1) comprenant :
- un sérialiseur (3) comprenant une pluralité d'entrées (3a) configurées pour recevoir des signaux de données entrants, lesquels sont reçus en provenance d'une sortie d'un tampon (9), comprenant des paquets de données successifs correspondant à une pluralité de canaux, le sérialiseur (3) étant configuré pour sérialiser lesdits signaux de données entrants dans un signal de sortie,
- un premier oscillateur (5a) configuré pour fournir un premier signal d'horloge au sérialiseur (3),
- un deuxième oscillateur (5b) configuré pour fournir un deuxième signal d'horloge au sérialiseur (3),
- un premier dispositif de commutation rapide (7) possédant une première entrée (7a) liée au premier oscillateur (5a), une deuxième entrée (7b) liée au deuxième oscillateur (5b) et une sortie (7d) liée au sérialiseur (3), le premier dispositif de commutation rapide (7) étant configuré pour commuter entre un premier état de commutation, la première entrée (7a) étant liée à la sortie (7d), et un deuxième état de commutation, la deuxième entrée (7b) étant liée à la sortie (7d), **caractérisé en ce que** le procédé comprend les étapes suivantes :
- le premier dispositif de commutation rapide (7) est commuté dans le premier état de commutation,
- le sérialiseur (3) est piloté pour sérialiser les signaux de données entrants à une première fréquence de transmission en utilisant le premier signal d'horloge fourni par le premier oscillateur (5a), en cas de besoin de changer la fréquence de transmission du sérialiseur (3) de la première fréquence de transmission à une deuxième fréquence de transmission différente de la première fréquence,
si la différence entre la première et la deuxième fréquence est inférieure à un seuil prédéterminé,
- le deuxième oscillateur (5b) est réglé de sorte que le deuxième signal d'horloge correspond à la deuxième fréquence de transmission et,
- le premier dispositif de commutation rapide (7) est commuté dans le deuxième état de commutation,
- le sérialiseur (3) est piloté pour sérialiser les signaux de données entrants en utilisant le deuxième signal d'horloge fourni par le deuxième oscillateur (5b),
si la différence entre la première et la deuxième fréquence est plus grande qu'un seuil prédéterminé,
- le deuxième oscillateur (5b) est réglé de sorte que le deuxième signal d'horloge correspond à une fréquence intermédiaire à l'intérieur de la plage entre la première et la deuxième fréquence,
- le dispositif de commutation rapide (7) est commuté dans le deuxième état de commutation,
- le sérialiseur (3) est piloté pour sérialiser les signaux de données entrants en utilisant le deuxième signal d'horloge fourni par le deuxième oscillateur (5b) correspondant à la fréquence intermédiaire,
- le premier oscillateur (5a) est réglé de sorte que le premier signal d'horloge correspond à la deuxième fréquence,
- le dispositif de commutation rapide (7) est commuté dans le premier état de commutation,
- le sérialiseur (3) est piloté pour sérialiser les signaux de données entrants en utilisant le premier signal d'horloge fourni par le premier oscillateur (5a) correspondant à la deuxième fréquence
et les étapes de commutation du dispositif de commutation rapide (7) du premier au deuxième état de commutation ou du deuxième au premier état de commutation étant réalisées pendant un intervalle inter-paquets des signaux de données entrants dans le sérialiseur (3).

12. Procédé selon la revendication 11, l'émetteur (1) comprenant également :
- un convertisseur numérique-analogique (15) lié à la sortie du sérialiseur (3),
- un deuxième dispositif de commutation rapide (7') possédant une première entrée (7'a) liée au premier oscillateur (5a), une deuxième entrée (7'b) liée au deuxième oscillateur (5b) et une sortie (7'd) liée au convertisseur numérique-analogique (15), le deuxième dispositif de commutation rapide (7') étant configuré pour commuter entre un premier état de commutation, la première entrée (7'a) étant liée à la sortie (7'd), et un deuxième état de commutation, la deuxième entrée (7'b) étant liée à la sortie (7'd), le deuxième dispositif de commutation rapide (7') étant synchronisé avec le premier dispositif de commutation rapide (7) pour commuter d'un état de commutation à l'autre.
